(19) Europäisches Patentamt
European Patent Office
Office européen des brevets

(11) **EP 2 136 469 B1**

(12) **EUROPEAN PATENT SPECIFICATION**

(45) Date of publication and mention
of the grant of the patent:
**18.05.2011   Bulletin 2011/20**

(51) Int Cl.:
*H03F 1/32* (2006.01)

(21) Application number: **08425429.1**

(22) Date of filing: **18.06.2008**

(54) **Method of high power amplifiers transfer function linearization by adaptively calculating main intermodulation products of radiofrequency harmonic cancellation**

Verfahren zur Übertragungsfunktionslinearisierung von Hochleistungsverstärkern mittels adaptiver Berechnung der Hauptintermodulationsprodukte hochfrequenter harmonischer Auflösung

Procédé de linéarisation de fonction de transfert d'amplificateurs grande puissance par le calcul adaptatif des produits principaux d'intermodulation de l'annulation des harmoniques de radiofréquence

(84) Designated Contracting States:
**AT BE BG CH CY CZ DE DK EE ES FI FR GB GR HR HU IE IS IT LI LT LU LV MC MT NL NO PL PT RO SE SI SK TR**

(43) Date of publication of application:
**23.12.2009   Bulletin 2009/52**

(73) Proprietors:
• **Nokia Siemens Networks S.p.A.**
**20126 Milano (IT)**
• **Nokia Siemens Networks OY**
**02610 Espoo (FI)**

(72) Inventor: **Di Donna, Giambattista**
**20064 Gorgonzola (IT)**

(74) Representative: **Fischer, Michael**
**Nokia Siemens Networks GmbH & Co. KG**
**Intellectual Property Rights**
**P.O. Box 80 17 60**
**81617 München (DE)**

(56) References cited:
WO-A-2005/124995      GB-A- 2 380 079
US-B2- 6 683 495      US-B2- 7 333 559

• YAN YE ET AL: "Generalized Hammerstein-Based Dynamic Nonlinear Behavior Models for Wideband RF Transmitters" WIRELESS COMMUNICATIONS, NETWORKING AND MOBILE COMPUTING, 2007. WICOM 2007. INTERNATIONAL CONFERENCE ON, IEEE, PISCATAWAY, NJ, USA, 21 September 2007 (2007-09-21), pages 684-687, XP031216780 ISBN: 978-1-4244-1311-9
• ANDING ZHU ET AL: "Pruning the Volterra Series for Behavioral Modeling of Power Amplifiers Using Physical Knowledge" IEEE TRANSACTIONS ON MICROWAVE THEORY AND TECHNIQUES, IEEE SERVICE CENTER, PISCATAWAY, NJ, US, vol. 55, no. 5, 1 May 2007 (2007-05-01), pages 813-821, XP011181002 ISSN: 0018-9480
• DING L ET AL: "Effects of Even-Order Nonlinear Terms on Power Amplifier Modeling and Predistortion Linearization" IEEE TRANSACTIONS ON VEHICULAR TECHNOLOGY, IEEE SERVICE CENTER, PISCATAWAY, NJ, US, vol. 53, no. 1, 1 January 2004 (2004-01-01), pages 156-162, XP011106224 ISSN: 0018-9545

EP 2 136 469 B1

## Description

## FIELD OF THE INVENTION

The present invention relates to the radio link systems employing linear modulations like M-QAM, OFDM and CDMA for an efficient use of the available bandwidth and therefore suffering the non linear effects of high power amplifiers (HPA) at the transmitter side. The invention particularly relates to a method of high power amplifiers transfer characteristic linearization by adaptively calculating main intermodulation products of radiofrequency harmonic cancellation. (Used acronyms and bibliographic references are given at the end of the description).

## BACKGROUND ART

Final RF amplifiers deliver high power transmission signals to the transmitting antennas for irradiation. As known, the input/output transfer characteristic of the high power amplifiers suffers from non-linearity due to saturation of the gain of amplifier. In other words, the output power of the transmitted signal is no more proportional to the power of input signal but tend to be nearly constant at a highest value. Whether not adequately provided, the amplified signal is distorted and new frequencies, not present in the original signal, are created. These new frequencies includes multiple of the symbol frequency, the so-called "harmonics", and a plurality of intermodulation (IMD) products characterized by their order in the polynomial "memoryless" approximation of the function $y(t) = f\left(x(t)\right) = \sum_{n=0}^{N} a_n x^n\left(t\right)$ describing the output signal, being $x(t)$ a band-limited input signal. Term "memoryless" means that the output is a function of the input at the actual time only. Harmonics lie by definition out of useful band, while the intermodulation products can lie both in-band and out-of-band. The frequency components which lie out-of-band can be removed by filtering, but the intermodulation products lying in-band or near the limits cannot be removed by filtering and usually constitutes the non linear component included in the distorted signal. Minimisation of in-band intermodulation products may advantageously exploit a mathematical model of the high power amplifier.

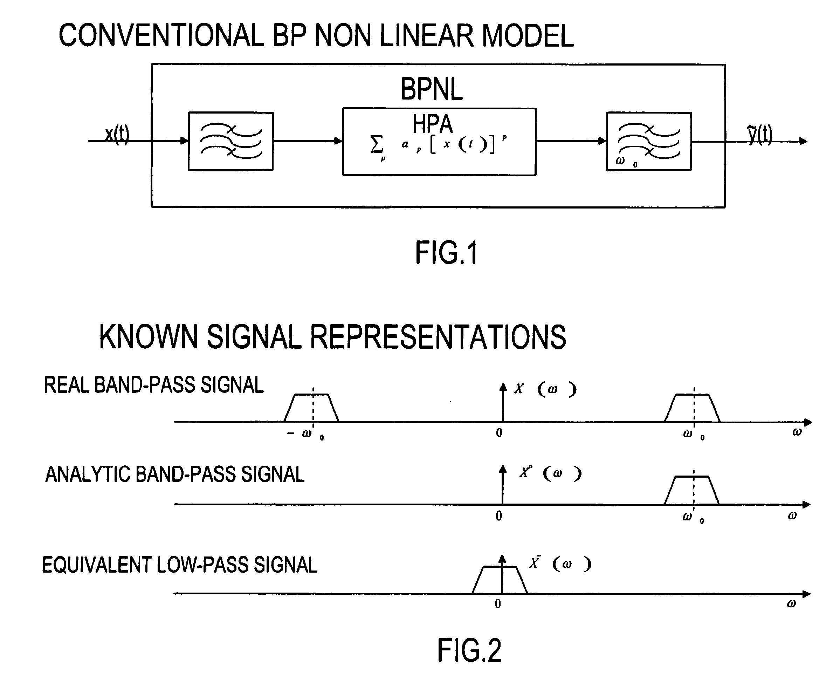

Several analytical models of distorting amplifiers are described in technical literature, valid for the frequency or the time domain, but to the aim of the present invention only a bandpass memoryless model is used similar to the one represented in **fig.1**. With reference to the figure, we see a bandpass non linear stage BPNL constituted by a high power amplifier HPA and two bandpass filters placed at the input, for an input signal $x(t)$, and at the output for an output signal $y(t)$, respectively.

With reference to **fig.2,** it is known from signal theory that any narrowband real signal $x(t)$ (having the symmetrical spectra around the origin visible at the top of the figure) can be reconstructed by the only knowledge of the spectrum with positive frequencies (the analytic representation at the centre part of the figure). The analytic signal in the time domain can be written in the form: $x(t)=x(t)e^{j\omega_0 t}$, where $\omega_o = 2\pi f_o$ is the pulsation of the RF carrier, and $\tilde{x}(t)$ (generally complex) is a baseband signal called the "complex envelope" or "equivalent low-pass signal" associated with the real signal $x(t)$. The spectrum of $\tilde{x}(t)$ is represented in the bottom part of the figure. The non linear band-pass behaviour of HPA present in the output signal $y(t)$ can be described by a power series of input signal $x(t)$, where these signals are both real band-pass signals. The relationship between corresponding low-pass equivalent signals $\tilde{x}(t)$ and $\tilde{y}(t)$ is given by the memoryless Volterra's series:

$$\tilde{y}(t) = \gamma_1 \tilde{x}(t) + \gamma_3 \left|\tilde{x}(t)\right|^2 \tilde{x}(t) + \gamma_5 \left|\tilde{x}(t)\right|^4 \tilde{x}(t) + \ldots\ldots + \gamma_{2m+1} \left|\tilde{x}(t)\right|^{2m} \tilde{x}(t), \qquad (1)$$

where first term is the linear component (undistorted), the second one is the third harmonic contribute, the third one is the fifth harmonic, and so on. The only odd harmonics of symbol frequency are present, as in the two-tone measurement signal used to evaluate the sinusoidal inter-modulation behaviour of the HPA. According to Equation 1 the non linearity decay in the transmitted signal consists in the presence of harmonic contributes, generally decreasing in power with the increasing of their order.

In order to counteract the side effects of non linearity in HPAs, a lot of solutions have been proposed in the past, some most representative linearization schemes will be discussed hereafter.

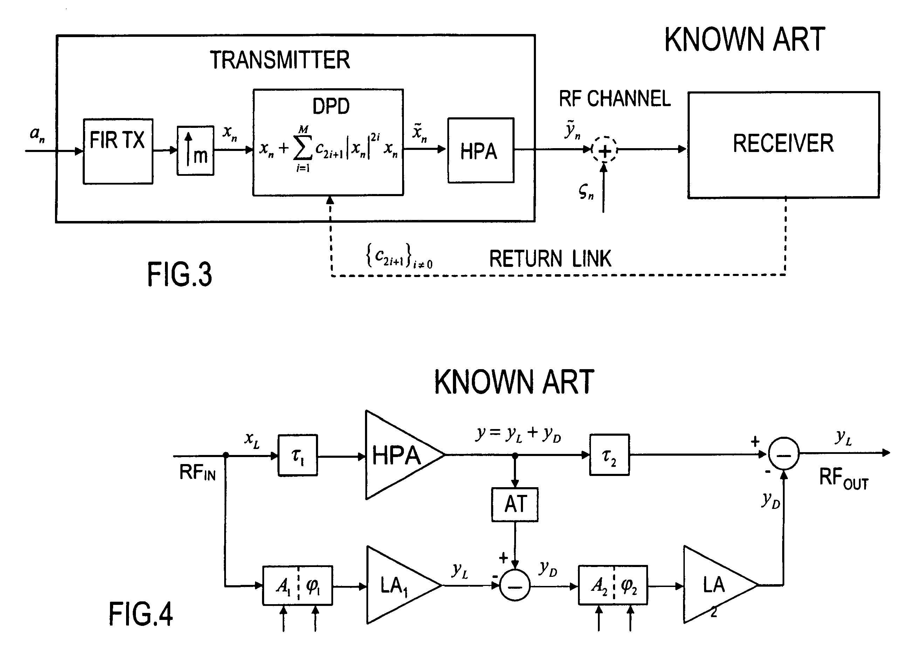

A family of linearization techniques makes use of a predistortion device placed upstream the distorting amplifier to the aim of approximating the inverse of its non linear transfer characteristic. Predistortion is a simple and reliable technique largely used in the past even with analog devices. Starting from equation 1 and the diagram of **fig.3,** a digital predistortion technique is described in a patent of the same applicant mentioned at **[Ref.8]. In fig.3,** the DPD block represents a digital predistorter placed upstream the distorting amplifier HPA. The coefficients used by predistorter DPD are updated by the receiver and transmitted back on the return link. The updating exploits the digital processing of remote demodulator for extracting the non linear correlations embodied into the odd coefficients other than the first one. Of coarse, the resort to the remote receiver is suitable for point-to-point radio links, whereas in point-to-multipoint radio systems like UMTS and WiMAX a local demodulator must be built at the transmitter side.

Wide-sense distortion cancellation is a linearization technique that appears in two patent applications mentioned at **[Ref.1] and [Ref.2].**

The system described in **[Ref.1]** (WO 03/021767 A1) combines "an auxiliary non-linear block " to a functional block of the system to increase linearity in the output signal, but it leaves quite undefined this auxiliary block.

The system described in **[Ref.2]** (US 2003/0234687 A1) includes an error generator whose output signals are combined with the main HPA output signal to subtract out its distortion. The error generator includes two auxiliary amplifiers, wherein one operates in the saturation region with the same non linearity characteristic of the HPA, and the other is linear; in this way the linear contribute is cancelled and the only inter-modulation products remain as an approximate replica of the HPA distortion. The weakness of this technique consists of: A) the difficulty of finding two amplifiers with the same non linear characteristic; B) the criticality of matching amplitude, phase, and timing alignment of the HPA output signal with the other one which is a replica of its distortion (an adaptive algorithm is missing).

A slightly different distortion cancellation technique is referenced in the technical literature with the name of "Feedforward Linearization" and it has been extensively proposed for the UMTS radio system and DVB standard, where linear modulations as the W-CDMA and OFDM are respectively used on one hand, and high transmitter power demand exists on the other hand. The basic concept in this technique consists of separating the distortion contribute from the linear component in the HPA output signal, and successively injecting it again with inverted sign at the HPA output after a right scaling, phase and timing balance has been established, as sketched in the block diagram of fig.4, where the "L" and "D" subscript stand for the linear and the distortion component, respectively, of each indicated signal.

With reference to **fig.4,** $RF_{IN}$ and $RF_{OUT}$ are the radiofrequency input and the output signals of the feedforward linearized transmitter; $LA_1$ and $LA_2$ are two linear amplifiers; AT is an attenuator of the amplified (distorted) signal $y = y_L + y_D$ *at* the output of HPA; $\tau_1$ and $\tau_2$ are two fixed delays at the input and at the output of HPA; $A_1$ and $\varphi_1$ are the amplitude and the phase of the undistorted signal $x_L$ at the input of the first linear amplifier $LA_1$; and $A_2$ and $\varphi_2$ are the amplitude and the phase of the only distortion component $y_D$ at the input of the second linear amplifier $LA_2$. As it can be argued, the criticality in this technique consists in the alignment of amplitude, phase, and delay of signals at the input of the two subtraction nodes.

Many papers and patent applications try to solve this problem:

- In **[Ref.3]** the amplitude $A_1$ and the phase $\varphi_1$ are recovered by an "auxiliary first loop controller", whereas the delay $\tau_1$ is fixed; also $A_2$ and $\varphi_2$ are settled by a "gain and a phase adjuster with a third loop controller". The fixed delay $\tau_2$ is power consuming on the main transmission path, reducing the output power.

- In **[Ref.4]** amplitude, phase and time alignment are approached by a "multi-branch adjuster system", but a fixed decay $\tau_2$ remain on the main path, with the same drawback as before.

- In **[Ref.5]** the linear signal $y_L$ at the first subtraction node of **fig.4** is recovered from the base-band and up-converted, so getting a correct signal error ($y_D$ in fig.4) as output of the first comparison, but not aligned for the second subtraction node. Moreover the delay $\tau_2$ remain fixed and power consuming on the main transmit path.

- In **[Ref.6]** the secondary branch of **fig.4** is transferred in baseband by two down-conversions for the input and output HPA signals. The whole non-linear HPA characteristic is reconstructed at base-band as well as the error signal $y_D$, which then requires an up-conversion to be combined at RF level at the second subtraction node. In this way the error signal alignment can be completely driven from the base-band, eliminating the power consumption delay $\tau_2$ , but no algorithm is given for.

Additional art is known from US6683495, WO2005/124995, US7333559, and from the IEEE articles 'Generalized Hammerstein-Based Dynamic Nonlinear Behavior Models for Wideband RF Transmitters', by Yan Ye et al, IEEE Wicom 2007; 'Pruning the Volterra Series for Behavioral Modeling of Power Amplfiers Using Physical Knowledge', by Zhu et al, IEEE trans. on Microwave Theory and Techniques, 2007; and 'Effects of Even-Order Nonlinear Terms on Power Amplifier Modeling and Predistortion Linearization', by Ding et al, IEEE trans. on Vehicular Technology 2004.

In conclusion, the Feedforward Linearization is a powerful technique, but it suffers the drawback of the error signal alignment and the weakness in founding algorithms correctly working, being inherent in its empirical distortion approach in which the distortion cancellation signal is obtained from the high power amplifier itself, or from a similar one.

## SUMMARY OF THE INVENTION

Object of the present invention is that to overcome the defects of linearizers of the prior art, especially of feed-forward and wide-sense type.

The invention achieves said object by providing a method of linearizing the transfer characteristic of a radiofrequency high power distorting amplifier, the method including the following steps:

a) calculate a memoryless Volterra's series of the input signal, whose terms are multiplied by respective coefficients of the powers, limitedly to the only odd order non-linear polynomial terms of the series modelling the most significant intermodulation products generated by the distorting amplifier;

b) subtract the analog radiofrequency value of the series from the distorted signal at the output of high power amplifier, so obtaining a linearized transmission signal;

c) calculate new multiplicative coefficients of odd order terms of truncated Volterra's series by imposing the achievement of minimum mean square error between a baseband digital representation of the linearized transmission signal and its digital linear counterpart, as disclosed in claim 1.

Further subject of the invention is a linearizer of the transfer characteristic of a radiofrequency high power distorting amplifier, operating in accordance with the method of claim 1.

Other aspects of the invention deemed to be novel are described in dependent claims.

According to an embodiment of the invention, the coefficient calculation step c) is carried out in close form by solving a mathematical system of linear equations of samples of the input signal and of the output signal of distorting amplifier; the mathematical system being suitable to be expressed in matrix form.

According to an alternative embodiment of the invention, the coefficient calculation step c) is carried out recursively from samples of the input signal and of the linearized transmission signal.

According to the invention, the samples of input signal are opportunely digitally delayed before being used in step a), to the aim of time aligning the Volterra's series terms to the corresponding intermodulation products in the output signal of high power amplifier.

According to the invention, the input signal is oversampled up to at least $2M$ times the symbol frequency, where $2M + 1$ is the highest order term of truncated Volterra's series.

According to the invention, the samples of input signal are opportunely digitally delayed before being used in step c), to the aim of time aligning them to the baseband digital representation of the linearized transmission signal. The two above delays are independent of each other.

According to the invention, at step b) the analog radiofrequency value of Volterra's series undergoes:

- bandpass filtering within a bandwidth of nearby four times the symbol frequency;
- amplification for aligning its power level to the power level of intermodulation products to be cancelled.

Independently of the one or the other embodiment of the invention, step a) includes:

- take the module of every sample;
- multiplying it by itself $2i$ times for each value of index i unitary incremented to assume the values from 1 to $M$ ;
- multiplying each power obtained at the preceding step by the actual sample of the input signal and by the respective coefficient so obtaining said odd order terms of truncated Volterra's series.

In conclusion, the invention proposes a harmonic cancellation technique aimed to identifies the inter-modulation contributes present in the amplified signal just as modelled by corresponding terms of a polynomial series and then subtract out these terms up to the $(2M + 1)^{th}$, leaving the only linear contribute in the transmitted signal together with harmonic contributes of higher order whose weights are progressively vanishing. The harmonic terms in the series are generated by digital circuits working in base-band; this is not a difficult task today, what instead is critical is the exact determination of the complex coefficients of each term of the series. This last operation is made possible and reliable as the transmitted signal is continuously compared with the linear-one available at the input of the high power distorting amplifier, in such a way of generating a difference (or error) signal between them, which must be held as low as possible in the mean square sense.

Profitably, the proposed harmonic cancellation works on the direct distortion characteristic of the HPA by means of a parallel digital harmonic generator with coefficients which depend on the non linearity of HPA and its time-variant working point and therefore they need to be dynamically determined in adaptive way.

Profitably, the proposed harmonic cancellation is more powerful than predistortion (despite predistortion is simpler and less expensive technique) as it can better exploit the gain of HPA up to 6 dB more than predistortion at the same output back off (OBO).

**BRIEF DESCRIPTION OF THE DRAWINGS**

The invention and its advantages may be understood with reference to the following detailed description of an embodiment thereof taken in conjunction with the accompanying drawings given for purely non-limiting explanatory purposes and wherein:

-    **fig.1** shows a conventional bandpass non linear model of a high power radiofrequency amplifier;
-    **fig.2** shows the bandpass spectra of a band-limited signal and its low-pass equivalent known as complex envelope;
-    **fig.3** shows a diagram of a transmission system including a digital predistorter controlled by the remote demodulator on the return link, according to a known configuration;
-    **fig.4** shows a diagram of a feed-forward linearizer of the prior art;
-    **fig.5** shows a diagram of a transmitter configured to perform adaptive harmonic cancellation according to a first embodiment of the present invention;
-    **fig.6** shows a diagram of a transmitter configured to perform adaptive harmonic cancellation according to a second embodiment of the present invention;
-    **fig.7a** shows some significant superimposed spectra of a 128 QAM modulated signal at the output of a high power amplifier without linearizer;
-    **fig.7b** shows some significant superimposed spectra of the 128 QAM modulated signal at the output of a high power amplifier with predistorter;
-    **fig.7c** shows some significant superimposed spectra of the 128 QAM modulated signal at the output of a high power amplifier with the harmonic cancellation of the present invention;
-    **figures 8a, 8b** show possible vectorial summations of distortion contributes.

**DETAILED DESCRIPTION OF SOME EMBODIMENTS OF THE INVENTION**

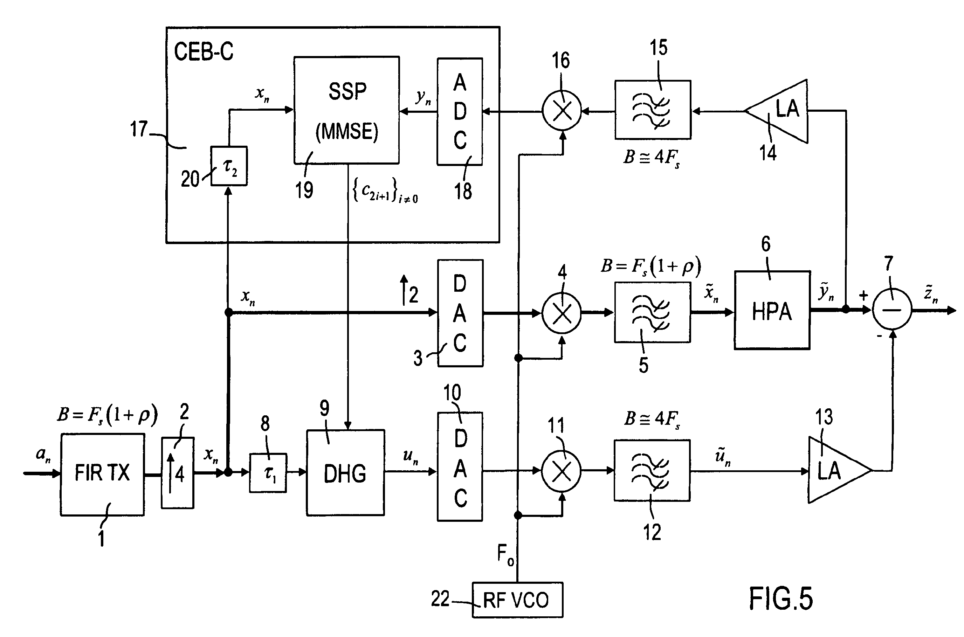

**Fig.5** shows the functional architecture of a transmitter suitable to point-to-point radio links, like SDH, and point-to-multipoint radio systems, like UMTS and WiMAX, both systems exploiting linear modulations. The transmitter substantially includes three paths, namely: a main transmission path indicated with thicker arrows; a linearization path parallel to the main path in the bottom part of the figure; and a feedback path visible in the upper part of the figure. Every path is shared by digital and analog blocks. All digital signals are represented by samples without any accents, while analog bandpass signals are represented by samples with tilde accent.

Along the main transmission path are cascaded: a FIR transmission filter 1, a sampler 2, a Digital-to-analog converter 3, a mixer 4, a bandpass filter 5, and a high power microwave amplifier 6. The output port of amplifier 6 is coupled to the summation input of an analog subtractor 7. Along the linearization path departing from the output of sampler 2 are cascaded: a digital delay 8, a Digital Harmonic Generator 9 (DHG), a digital-to-analog converter 10, a mixer 11, a bandpass filter 12, and a linear amplifier 13. The output port of linear amplifier 13 is coupled to the subtraction input of the analog subtractor 7. The output port of HPA 6 is coupled to the input port of a linear amplifier 14 on the feedback path. The output port of amplifier 14 is coupled to the cascade of a bandpass filter 15, a mixer 16, a coefficient evaluation block 17 (CEB-C where suffix C is for calculator) which receives samples $x_n$ of the input signal $a_n$ produced by a sampler 2, and calculates $M$ coefficients $\{c_{21+1}\}_{i \neq 0}$ directed to a further input of DHG 9. The block 17 also includes an analog-to-digital converter 18 (cascaded to the mixer 16), a System Solving Processor 19 (SSP) cascaded to the ADC 18, and a digital delay 20 of samples $x_n$. The delayed $x_n$ samples reach the SSP block 19.

In operation, $a_n$ are the transmitted information symbols (often complex as in M-QAM modulations), available at symbol rate Fs, which enter the pulse shaping filter 1, without limitation of the root raised cosine type with assigned roll-off p and bandwidth $F_s (1 + \rho)$. The filtered signal is up-sampled by a factor $m = 4$ to give a linear transmission signal $x_n$ entering block DHG 9 after being delayed of $\tau_1$ μs by digital delay 8. Block DHG 9 is represented by a mathematical expression similar to the Eq.1, which aims to reconstruct the distortion present in the HPA output signal, so its input-output relationship in sampled form is:

$$u_n = \sum_{m=1}^{M} c_{2m+1} \left| x_n \right|^{2m} x_n$$

The signal $u_n$ is then analog converted by DAC 10 and up-converted to microwave by mixer 11 piloted by a transmission carrier $F_o$ generated by a VCO 22. The selected transmission band is set by the bandpass filter 12 and

the $\tilde{u}_n$ signal is further amplified by the linear amplifier 13 (LA).

It is worthwhile to observe that the harmonic generation must be executed with a sampling bandwidth that is enough to manage the harmonic terms correctly. If the fifth order term is the last one, i.e. ($M = 2$), a sampling bandwidth of $4F_s$ ($m = 4$) is sufficient on the whole linearization chain where the DGH 9 is inserted, whereas the bandwidth on the main TX chain, from the output of FIR TX 9 up to the input of HPA 6, is $F_s(1 + \rho)$, as usual, and a sampling of $m = 2$ is sufficient. Accordingly, the bandwidth on the feedback path from the output of HPA 6 to the output of SSP 19 is $4F_s$.

On the main transmission path (thicker arrows) two out four $x_n$ samples per symbol are converted to analog by DAC 3, and then up-converted to microwave by mixer 4 piloted by the carrier $F_O$. The selected transmission band is set by the bandpass filter 5 whose output linear signal $\tilde{x}_n$ enters the high power amplifier 6. Signal $\tilde{y}_n$ at the output of HPA 6 enters the input + of the analog subtractor 7, while the analog distortion signal $\tilde{u}_n$ enters the input - of the same device to be subtracted from $\tilde{y}_n$ so achieving the linearized transmitted signal $\tilde{z}_n$. Correctness of harmonic cancellation is optimized by setting that value of delay $\tau_1$ which performs timing alignment between the $\tilde{y}_n$ and $\tilde{u}_n$ signals. Harmonic cancellation consists of subtracting the artificially generated distortion terms at the output of DHG 9 from the corresponding intermodulation products generated by the high power amplifier HPA 6.

On the feedback path, the level of $\tilde{y}_n$ signal at the output of HPA 6 is adjusted by the linear amplifier 14 and filtered by the bandpass filter 15. The filtered signal is down-converted to baseband by mixer 16 piloted by $F_o$ and digital converted by ADC 18. The digital signal $\tilde{y}_n$ so obtained together with the linear signal $x_n$ are processed by the SSP processor inside the CEB-C block for obtaining a new set of coefficients $\{C_{2l+1}\}_{i \neq 0}$ to be provided to the DHG block 9. Correctness on coefficient calculation is assured by the delay $\tau_2$ which stands for time alignment between the transmitted signal $z_n$ available in baseband and its linear version $x_n$.

Furthermore in operation, all signals indicated in **fig.5** may be considered as N-sample sequences ($N \geq 10{,}000$ is enough) with finite mean power $P_x$ :

$$P_x \triangleq \frac{1}{N}\sum_{n=1}^{N}\left|x_n\right|^2 = \frac{1}{N}\sum_{n=1}^{N}x_n x_n^* = \left\langle x_n, x_n \right\rangle$$

and mutual power $P_{xy}$ defined as:

$$P_{xy} \triangleq \frac{1}{N}\sum_{n=1}^{N}x_n y_n^* = \left\langle x_n, y_n \right\rangle .$$

The coefficients $c_{2l+1}$ are determined by the minimization of the Mean Square Error (MSE) between the transmitted signal $\tilde{z}_n$ and its linear version $x_n$ with respect to the coefficients $c_{2l+1}$ themselves for $0 \leq i \leq M$, which leads to the linear equation system:

$$\sum_{m=0}^{M}c_{2m+1}\left\langle \left|x_n\right|^{2m}x_n, \left|x_n\right|^{2i}x_n\right\rangle = \left\langle y_n, \left|x_n\right|^{2i}x_n\right\rangle, \qquad \text{for } 0 \leq i \leq M . \qquad (2)$$

The mathematical passages leading to the system of Eq.2 are detailed in the following. The MSE is defined as:

$$MSE \triangleq \frac{1}{N}\sum_{n=1}^{N}\left|\varepsilon_n\right|^2 \triangleq \left\langle \varepsilon_n, \varepsilon_n \right\rangle, \text{ where} \qquad (3)$$

$$\varepsilon_n \stackrel{\wedge}{=} c_1 x_n - z_n = c_1 x_n - y_n + \sum_{m=1}^{M} c_{2m+1} |x_n|^{2m} x_n = \sum_{m=0}^{M} c_{2m+1} |x_n|^{2m} x_n - y_n \tag{4}$$

Minimization of Eq.3 needs of calculation of partial derivatives with respect to $c_{2i+1}$ and zeroing them as:

$$0 = \frac{\partial \langle \varepsilon_n, \varepsilon_n \rangle}{\partial c_{2i+1}} = 2 \left\langle \varepsilon_n, \frac{\partial \varepsilon_n}{\partial c_{2i+1}} \right\rangle$$
$$= 2 \left\langle \varepsilon_n, |x_n|^{2i} x_n \right\rangle = 2 \left\langle \sum_{m=0}^{M} c_{2m+1} |x_n|^{2m} x_n - y_n, |x_n|^{2i} x_n \right\rangle. \tag{5}$$

Because of the linearity of scalar product $\langle \cdots, \cdots \rangle$ in both its arguments, Eq.2 is obtained consequently. It is convenient render the scalar products of Eq.2 explicit in order to highlight the system of linear equations in matrix form:

$$\left\langle |x_n|^{2m} x_n, |x_n|^{2i} x_n \right\rangle = \frac{1}{N} \sum_{n=1}^{N} |x_n|^{2(i+m+1)} \stackrel{\wedge}{=} [\mathbf{A}]_{i,m} \qquad \text{for} \quad 0 \le i, m \le M \tag{6}$$

$$\left\langle y_n, |x_n|^{2i} x_n \right\rangle = \frac{1}{N} \sum_{n=1}^{N} y_n |x_n|^{2i} x_n^* \stackrel{\wedge}{=} [\mathbf{b}]_i \qquad \text{for} \quad 0 \le i \le M \tag{7}$$

so that the Eq.2 can be put in the matrix form:

$$\mathbf{A} \mathbf{c} = \mathbf{b}, \tag{8}$$

where $\mathbf{c}$ is the vector of coefficients $c_{2i+1}$ calculated by block SSP 19; e.g. by inversion of matrix $\mathbf{A}$ or by any known numerical method of system solving. It is important pointing out that the only signals $x_n$ and $y_n$ are needed for the solution of Eq.2 and not the baseband version of transmitted signal $z_n$.

Instead of solving the Eq.8 in close form, as well known in technical literature, the Least Mean Square (LMS) algorithm can be used to update the coefficients $c_{2i+1}$ iteratively, e.g. as described in **[Ref.10],** paragraph 11.1.2. The updating performs the "steepest descent" algorithm to continuously change each coefficient with variations proportional to the respective derivates of the error function MSE taken with opposite sign:

$$c_{2i+1}(n+1) = c_{2i+1}(n) - \alpha \frac{\partial \langle \varepsilon_n, \varepsilon_n \rangle}{\partial c_{2i+1}}$$

$$= c_{2i+1}(n) - \alpha \langle \varepsilon_n, |x_n|^{2i} x_n \rangle \qquad (9)$$

$$\approx c_{2i+1}(n) - \alpha \varepsilon_n |x_n|^{2i} x_n^{*}$$

$$c_{2i+1}(0) = 0 \qquad \text{for} \quad 0 \leq i \leq M$$

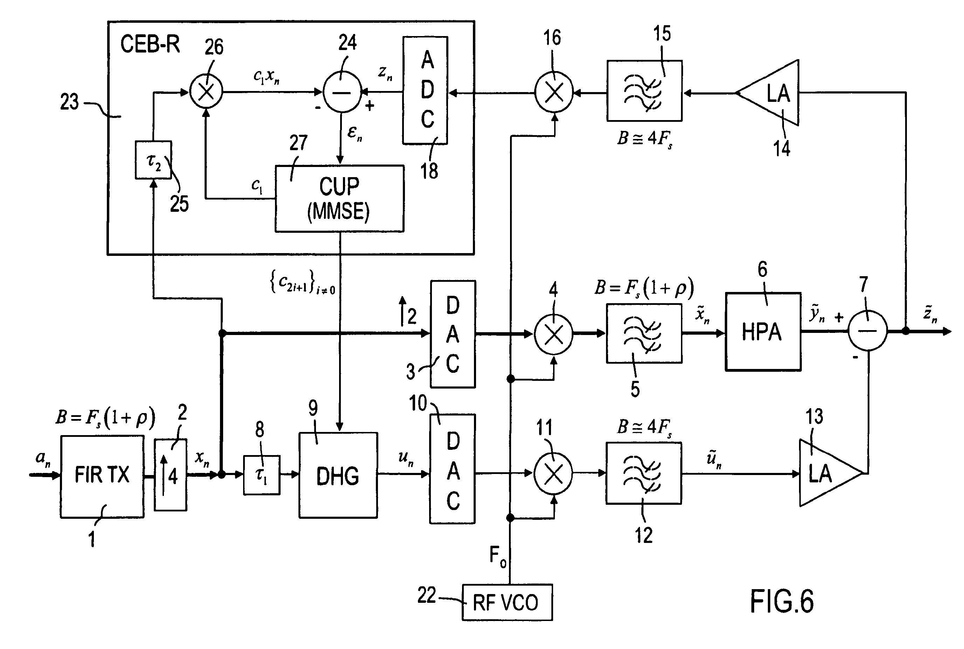

This second embodiment of the invention is shown in **fig.6,** where elements as in fig.5 are indicated with the same numbers. With reference to **fig.6** and Eq.9, the only differences with respect to the preceding embodiment are in the feedback path, as the error signal $\varepsilon_n = c_1 x_n - z_n$ must be calculated explicitly by a different architecture of the coefficient evaluation block CEB-R 23, where suffix R is for recursive. The linearized transmission signal $\tilde{z}_n$ at the output of the analog subtractor 7 reaches the input of the cascaded feedback blocks 14, 15, 16, and 18 to be converted to baseband in digital form. Block CEB-R 23 includes the ADC 18, a digital subtractor 24, a digital delay 25, a digital multiplier 26, and Coefficient Updating Processor (CUP) 27.

The samples $x_n$ of input signal $a_n$, produced by sampler 2, are delayed of $\tau_2$ by digital delay 25 and forwarded to the multiplier 26 to be multiplied by a first coefficient $c_1$ coming from the processor 27. The product $c_1 x_n$ reaches the input - of the subtractor 24, whose input + is reached by the digitalized signal $z_n$ and the difference present at the output is the error signal $\varepsilon_n$ feeding the CUP processor 27. This block calculates the $M + 1$ coefficients $c_{2i+1}$ iteratively according to Eq.9 and sends the $M$ coefficients $\{c_{2i+1}\}_{i\neq0}$ to the digital harmonic generator DHG 9 and a coefficient $c_1$ to the digital multiplier 26

As far as the implementation of transmitter is concerned, the blocks CEB-C 11 can be implemented by a DSP device for solving the linear equation system together with other FPGA auxiliary circuits, if the first invention embodiment of fig.5 is preferred.

In the case of the second embodiment of fig. 6 the CEB-R 23 can be implemented by a single device as FPGA or ASIC. The analog subtractor 7 is a microwave power combiner of signal $\tilde{y}_n$ and $\tilde{u}_n$ with any combination phase, being it automatically resolved by the complex coefficients $\{c_{2i+1}\}_{i\neq0}$.

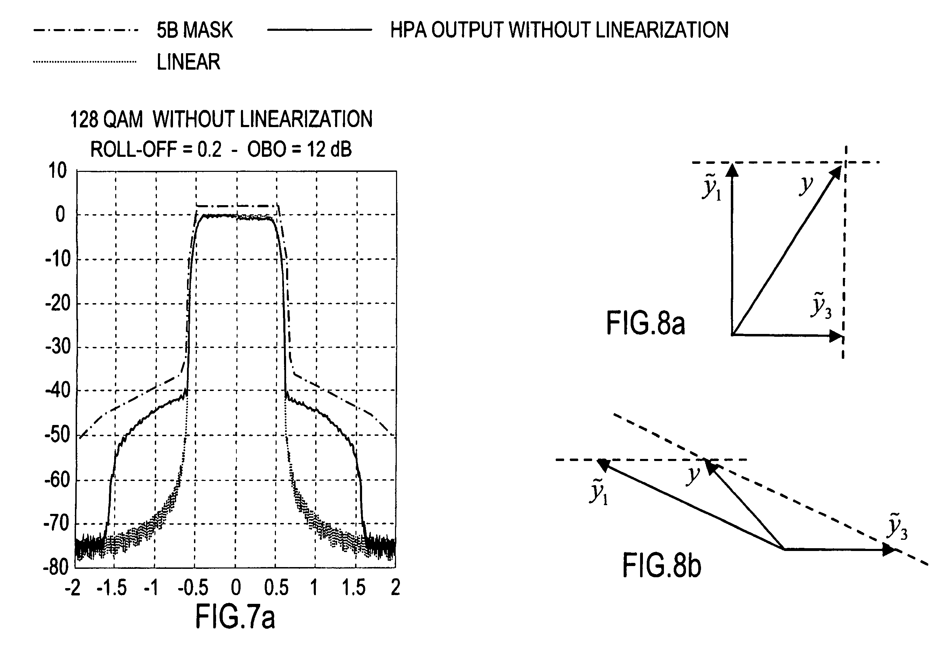

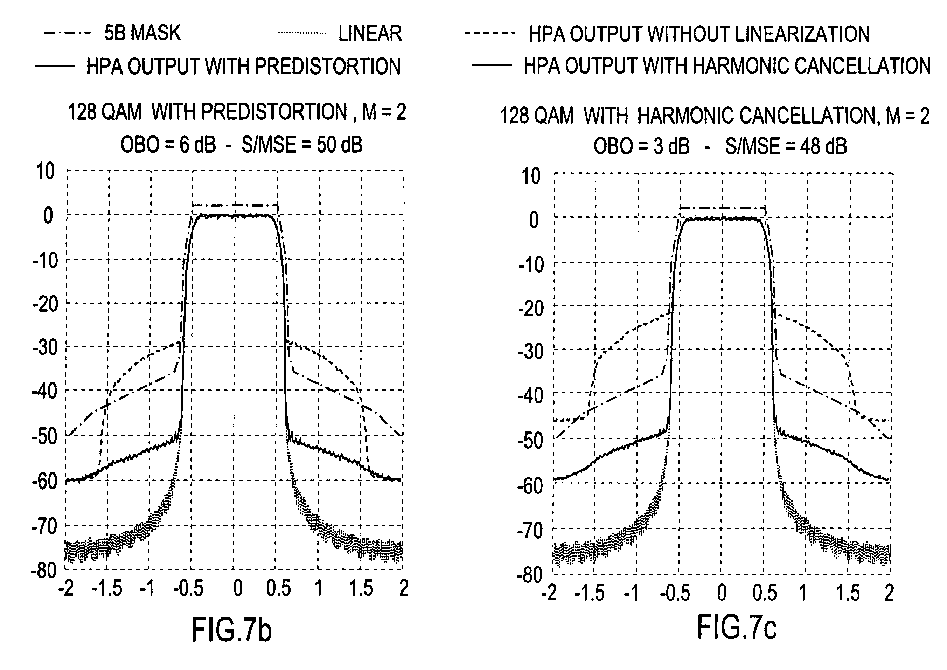

The performance of the harmonic canceller here proposed has been tested in comparison with predistorter described in [Ref.8] in the same simulation framework. Both linearizers are based on the Volterra's memoryless series with M = 2, but the harmonic cancellation is a more complex technique compared to predistortion, because it requires an auxiliary TX chain and to be time aligned with respect to the main TX chain, so it can be justified only if its linearization performance really exceeds what a predistorter does. The comparative test allows to quantitatively assess the performances of these different linearization techniques. The non linear HPA characteristic described in [Ref.9] has been used for both the linearization techniques, the modulation adopted is a 128 QAM with a roll-off of 0.2; the simulation results are shown in the **figures 7a, 7b,** and **7c**.

**Fig.7a** shows the transmitted spectrum without any linearization technique, where an output back-off (OBO) of 12 dB has been chosen to hold a reasonable margin with respect to the emission 5B mask required for SDH radio system. **Fig.7b** shows the transmitted spectrum with predistorter and OBO of 6 dB. **Fig.7c** shows the transmitted spectrum with harmonic canceller and OBO of 3 dB. In figures 8b and 8c are also shown the 5B mask, the linear spectrum, and the spectrum without linearization for appreciating the linearization effect (at the same OBO indicated in the figures).

When a linearization technique is employed, the OBO choice criterion is to have a spectrum profile better than without linearization, as well as a better Signal to MSE ratio a the receiver side. This leads to an OBO equal to 6 dB for the predistortion spectrum of **fig.7b** (with a net power gain of 6 dB in respect of **fig.7a),** and an OBO equal to 3 dB for the harmonic cancellation spectrum of **fig.7c .**

Now the net power gain takes into account the difference between the values of OBO, which refers only to the HPA output signal $\tilde{y}_n$ with an eventual increase (or decrease) in the actually transmitted signal $\tilde{z}_n$; as this latter equals the linear component in the former $\tilde{y}_n$, it could be erroneously argued that a power decrease is expected. The question is a little complicated, so let us simplify the problem assuming the HPA output signal as it contains two terms only, the linear component and the third order contribute, that is in sampled form:

$$\tilde{y}(n) = \gamma_1 \tilde{x}(n) + \gamma_3 |\tilde{x}(n)|^2 \tilde{x}(n) \triangleq \tilde{y}_1(n) + \tilde{y}_3(n) \qquad \Rightarrow \qquad \tilde{z}(n) \cong \tilde{y}_1(n)$$

and sketching this signal combination with a vector drawing as indicated in fig.8. **Fig.8a** refers to an orthogonal vectorial composition in which the amplitude of each component is less than their resultant. Of coarse for a different vectorial composition the amplitude of one component can be greater than the resultant, as in **fig.8b.** This latter situation is just what happens at the HPA output, where the linear component has greater power than the whole distorted signal: mathematically speaking, the signals at the right hand of Eq.1 are not each other orthogonal but only linearly independent. The simulation analysis, related to **fig.7c** has given a 2.3 dB increase in the power of the transmitted signal $\tilde{z}_n$, so we can assert a net power gain of 11.3 dB for the harmonic canceller (5.3 dB more than the predistorter).

Although the invention has been described with particular reference to some preferred embodiments, it will be evident to those skilled in the art, that the present invention is not limited thereto, but further variations and modifications may be applied without departing from the scope of the invention as defined by the annexed claims.

## ACRONYMS

| | |
|---|---|
| ASIC | Application Specific Integrated Circuit |
| BER | Bit Error Rate |
| BPNL | Bandpass Non-Linear |
| CDMA | Code Division Multiple Access |
| FDMA | Frequency Division Multiple Access |
| FIR | Finite Impulse Response |
| FPGA | Field Programmable Gate Arrays |
| HPA | High Power Amplifier |
| IMD | Intermodulation |
| ISI | Intersymbol Interference |
| MMSE | Minimum Mean Square Error |
| MSE | Mean Square Error |
| M-QAM | M-Quadrature Amplitude Modulation |
| OBO | Output Back-Off |
| OFDM | Orthogonal Frequency Division Multiplexing |
| SDH | Synchronous Digital Hierarchy |
| TDMA | Time Division Multiple Access |
| TWT | Travelling Wave Tube |
| UMTS | Universal Mobile Telecommunication System |
| HPA | High Power Amplifiers |
| WiMAX | Worldwide Interoperability for Microwave Access |

## BIBLIOGRAPHY

[1] H.S. Jeong, J. Park and K. Lee, "An adaptive linearization technique for communication building block", International Application Patent No. WO 03/021767 A1, 13 March 2003.

[2] G.F. Zhang, X. Wang, F. Concilio and T.S. Jao, "Wideband power amplifier linearization technique", U. S. Patent Application No. 2003/0234687 A1, December 25th, 2003.

[3] Arne Rydin, "Auxiliary amplifier in feedforward linearization amplification system", U.S. Patent Application Publication No 2003/0227325 A1, December 11, 2003.

[4] T. Johnson and J. K. Cavers, "Reduced architecture for multi-branch feedforward power amplifier linearizers", U.S. Patent Application Publication No 2003/0030487 A1, February 13th, 2003.

[5] J. Domokos, "A mobile phone base-station multicarrier amplifier with feedforward linearization", UK. Patent Application GB 2380079 A, 26.03.2003.

[6] E.G. Jeckeln, F.M. Ghannouchi, M. Sawan and F. Bearegard, "Efficient baseband/RF feedforward linearizer through a mirror power amplifier using software-defined Radio and quadrature digital up-conversion", 2001 IEEE MTT-S International Microwave Symposium Digest (Cat. No. 01CH37157), vol. 2.

[7] L. Erup, M. Gardner and R. A. Harris. "Interpolation in digital modems - Part II: Implementation and performance", IEEE Transactions on Communications, vol. 41, No 6, pp.997-1008, June 1993.

[8] R. Colombo, GB. Di Donna and S. Pagliaro, "Method for the linearization of a power stage of a signal transmitter, corresponding system and receiver", European Patent Application EP 1280272A1, priority 27.07.2001.

[9] A.A.M. Saleh, "Frequency independent and frequency-dependent nonlinear model of TWT amplifier ", Transactions on Communications, vol. COM-29, pp. 1715-1720, November 1981.

[10] J.G. Proakis, "Digital Communications" -4th Edition, McGraw-Hill 2001.

**Claims**

1. Method of linearizing the transfer characteristic of a radiofrequency high power distorting amplifier (6), **characterized in that** includes the following steps:

   a) calculate (9) a memoryless Volterra's series ($u_n$) of powers of samples ($x_n$) of an input signal ($a_n$) multiplied by respective coefficients ($\{c_{2l+1}\}_{i \neq 0}$) of the powers, limitedly to the only odd order non-linear polynomial terms of the series modelling the most significant intermodulation products generated by the distorting amplifier;
   b) subtract the analog radiofrequency value of the series ($\tilde{u}_n$) from the distorted signal ($\tilde{y}_n$) at the output of high power amplifier, so obtaining a linearized transmission signal ($\tilde{z}_n$);
   c) calculate new multiplicative coefficients ($c_{2m+1}$) of odd order terms of truncated Volterra's series by imposing the achievement of minimum mean square error between a baseband digital representation of the linearized transmission signal ($z_n$) and its digital linear counterpart given by the first order term ($c_1 x_n$) of the Volterra's series.

2. The method of claim 1, **characterized in that** the input signal ($a_n$) is oversampled up to at least $2M$ times the symbol frequency, where $2M+1$ is the highest order term of truncated Volterra's series.

3. The method of claim 2, **characterized in that** the coefficient calculation step c) is carried out by solving in close form a mathematical system of linear equations including samples ($x_n$) of input signal ($a_n$) and of output signal ($y_n$) of the distorting amplifier (6).

4. The method of claim 2, **characterized in that** the coefficient calculation step c) is carried out recursively from samples ($x_n$) of the input signal ($a_n$) and of linearized transmission signal ($z_n$).

5. The method of claim 2, **characterized in that** the samples ($x_n$) of input signal ($a_n$) are opportunely digitally delayed ($\tau_1$) before being used in step a), so time aligning the terms of Volterra's series to the corresponding intermodulation products present in the output signal of the high power amplifier (6).

6. The method of claim 2, **characterized in that** the samples ($x_n$) of input signal ($a_n$) are opportunely digitally delayed ($\tau_2$) before being used in step c), so time aligning them to the baseband digital representation of the linearized transmission signal ($z_n$).

7. The method of claim 2, **characterized in that** at step b) said analog radiofrequency value of Volterra's series ($\tilde{u}_n$) undergoes:

   - bandpass filtering with a bandwidth of nearby $4F_S$, where $F_S$ is the symbol frequency;
   - linear amplification (12) for aligning its power level with the level of intermodulation products to be cancelled.

8. The method of claim 1, **characterized in that** step a) includes:

   - taking the module of every sample ($x_n$);
   - multiplying it by itself 2i times for each value of index $i$ unitary incremented to assume values from 1 to $M$;
   - multiplying each power obtained at the preceding step by the actual sample ($x_n$) of the input signal and by the respective coefficient so obtaining said odd order terms of truncated Volterra's series.

9. The method of claim 3, **characterized in that** said mathematical system assumes the following expression:

$$\sum_{m=0}^{M} c_{2m+1} \left\langle |x_n|^{2m} x_n, |x_n|^{2i} x_n \right\rangle = \left\langle y_n, |x_n|^{2i} x_n \right\rangle \text{ for } 0 \le i \le M,$$

where:

$c_{2m+1}$ are the odd coefficients of Volterra's series; $x_n$ is a sample of the input signal $(a_n)$; $y_n$ is the $n^{\text{th}}$ sample at the output of distorting power amplifier (6); the angular parentheses indicate the scalar product of the two arguments separated by comma.

10. The method of claim 4, **characterized in that** the recursion at step c) assumes the following expression:

$$c_{2i+1}(n+1) \approx c_{2i+1}(n) - \alpha \varepsilon_n |x_n|^{2i} x_n^* \text{ for } 0 \le i \le M$$

and $c_{2i+1}(0) = 0$, where: $c_{2m+1}$ are the odd coefficients of Volterra's series; $x_n$ is a sample of the input signal $(a_n)$; * indicates complex conjugated;

$\varepsilon_n \triangleq c_1 x_n - z_n$ is the linearity error.

11. Linearizer of the transfer function of a radiofrequency high power distorting amplifier (6), **characterized in that** includes:

- first digital signal processing means (9) programmed for calculating a memoryless Volterra's series $(u_n)$ of powers of samples $(x_n)$ of an input signal $(a_n)$ multiplied by respective coefficients $(\{c_{21+1}\}_{i \ne 0})$ of the powers, limitedly to the only odd order non-linear polynomial terms of the series modelling the most significant inter-modulation products generated by the distorting amplifier (6);
- radiofrequency coupling means (7) configured for subtracting the analog radiofrequency value of the series $(\tilde{u}_n)$ from the distorted signal $(\tilde{y}_n)$ at the output of high power amplifier (6), so obtaining a linearized transmission signal $(\tilde{z}_n)$;
- second digital signal processing means (17, 23) programmed for calculating new multiplicative coefficients $(c_{2m+1})$ of odd order terms of truncated Volterra's series by imposing the achievement of minimum mean square error between a baseband digital representation of the linearized transmission signal $(z_n)$ and its digital linear counterpart $(c_1 x_n)$.

12. The linearizer of claim 11, **characterized in that** includes sampling means controlled for oversampling the input signal $(a_n)$ up to at least $2M$ times the symbol frequency, where $2M + 1$ is the highest order term of truncated Volterra's series.

13. The linearizer of claim 12, **characterized in that** the second digital signal processing means (17) are programmed for calculating said coefficients $(c_{2m+1})$ by solving in close form a mathematical system of linear equations including samples $(x_n)$ of input signal $(a_n)$ and of output signal $(y_n)$ of the distorting amplifier (6).

14. The linearizer of claim 12, **characterized in that** the second digital signal processing means (23) are programmed for calculating said coefficients $(c_{2m+1})$ recursively from samples $(x_n)$ of the input signal $(a_n)$ and of linearized transmission signal $(z_n)$.

15. The linearizer of claim 12, **characterized in that** includes first digital delay means (8) of the samples $(x_n)$ of input signal $(a_n)$ entering first digital signal processing means (9) for time aligning the Volterra's series terms to the corresponding intermodulation products.

16. The linearizer of claim 12, **characterized in that** includes second digital delay means (20, 25) of the samples $(x_n)$ entering the second digital signal processing means (23) for time aligning them to the baseband digital representation of the linearized transmission signal $(y_n, z_n)$.

17. The linearizer of claim 12, **characterized in that** downstream said first digital signal processing means (9) a cascade is included of: digital-to analog converting means (10), conversion to radiofrequency means (11), bandpass filtering means (12) with a bandwidth of nearby four times the symbol frequency, linear power amplifying means (12) for aligning the power level of distortion signal $(\tilde{u}_n)$ to the power level of intermodulation products to be cancelled.

**18.** The linearizer of claim 12, **characterized in that** includes a cascade of:

- linear power amplifying means (14) of the transmission signal ($y_n$, $z_n$) present at the output either of high power distorting amplifier (6) or the radiofrequency coupling means (7);
- bandpass filtering means (15) with a bandwidth of nearby four times the symbol frequency;
- radiofrequency down-converting means (16);
- analog-to-digital converting means (18) placed upstream the second digital signal processing means (17, 23).

**Patentansprüche**

**1.** Verfahren zum Linearisieren der Übertragungskurve eines verzerrenden Hochfrequenz-Leistungsverstärkers (6), **dadurch gekennzeichnet, dass** es die folgenden Schritte umfasst:

a) Berechnen (9) einer gedächtnislosen Volterrareihe ($u_n$) von Potenzen von Abtastwerten ($x_n$) eines Eingangssignals ($a_n$), die mit jeweiligen Koeffizienten ($\{c_{2l+1}\}_{i\neq0}$) der Potenzen multipliziert werden, beschränkt nur auf die nicht linearen Polynomterme ungerader Ordnung der Reihe, die die signifikantesten Intermodulationsprodukte, die durch den verzerrenden Verstärker erzeugt werden, modellieren;
b) Subtrahieren des analogen Hochfrequenzwerts der Reihe ($\tilde{u}_n$) von dem verzerrten Signal ($\tilde{y}_n$) am Ausgang des Hochleistungsverstärkers, um so ein linearisiertes Übertragungssignal ($\tilde{z}_n$) zu erhalten;
c) Berechnen von neuen multiplikativen Koeffizienten ($c_{2m+1}$) von Termen ungerader Ordnung der abgebrochenen Volterrareihe durch Auferlegen der Erzielung eines minimalen mittleren quadratischen Fehlers zwischen einer Basisband-Digitaldarstellung des linearisierten Übertragungssignals ($z_n$) und ihrem digitalen linearen Gegenstück, das durch den Term ($c_1 x_n$) erster Ordnung der Volterrareihe gegeben wird.

**2.** Verfahren nach Anspruch 1, **dadurch gekennzeichnet, dass** das Eingangssignal ($a_n$) bis zu mindestens 2 *M* mal die Symbolfrequenz überabgetastet wird, wobei 2 *M* + 1 der Term höchster Ordnung der abgebrochenen Volterrareihe ist.

**3.** Verfahren nach Anspruch 2, **dadurch gekennzeichnet, dass** der Koeffizientenberechnungsschritt c) durch Lösen eines mathematischen Systems linearer Gleichungen, das Abtastwerte ($x_n$) des Eingangssignals ($a_n$) und des Ausgangssignals ($y_n$) des verzerrenden Verstärkers (6) enthält, in geschlossener Form ausgeführt wird.

**4.** Verfahren nach Anspruch 2, **dadurch gekennzeichnet, dass** der Koeffizientenberechnungsschritt c) rekursiv aus Abtastwerten ($x_n$) des Eingangssignals ($a_n$) und des linearisierten Übertragungssignals ($z_n$) ausgeführt wird.

**5.** Verfahren nach Anspruch 2, **dadurch gekennzeichnet, dass** die Abtastwerte ($x_n$) des Eingangssignals ($a_n$) zweckmäßigerweise vor der Verwendung im Schritt a) digital verzögert ($\tau_1$) werden, um so die Terme der Volterrareihen zeitlich auf die in dem Ausgangssignal des Hochleistungsverstärkers (6) vorliegenden entsprechenden Intermodulationsprodukte auszurichten.

**6.** Verfahren nach Anspruch 2, **dadurch gekennzeichnet, dass** die Abtastwerte ($x_n$) des Eingangssignals ($a_n$) zweckmäßigerweise vor der Verwendung im Schritt c) digital verzögert ($\tau_2$) werden, um sie so zeitlich auf die Basisband-Digitaldarstellung des linearisierten Übertragungssignals ($z_n$) auszurichten.

**7.** Verfahren nach Anspruch 2, **dadurch gekennzeichnet, dass** im Schritt b) der analoge Hochfrequenzwert der Volterrareihe ($\tilde{u}_n$) Folgendem unterzogen wird:

- Bandpassfilterung mit einer Bandbreite von ungefähr 4 $F_S$, wobei $F_S$ die Symbolfrequenz ist;
- lineare Verstärkung (12) zum Ausrichten seines Leistungspegels mit dem Pegel der zu löschenden Intermodulationsprodukte.

**8.** Verfahren nach Anspruch 1, **dadurch gekennzeichnet, dass** Schritt a) Folgendes umfasst:

- Nehmen des Moduls jedes Abtastwerts ($x_n$);
- Multiplizieren dieses mit sich selbst 2*i* mal für jeden Wert des Index i, der unitär inkrementiert wird, um Werte von 1 bis M anzunehmen;
- Multiplizieren jeder in dem vorherigen Schritt erhaltenen Potenz mit dem tatsächlichen Abtastwert ($x_n$) des

Eingangssignals und mit dem jeweiligen Koeffizienten, um so die Terme ungerader Ordnung der abgebrochenen Volterrareihe zu erhalten.

9. Verfahren nach Anspruch 3, **dadurch gekennzeichnet, dass** das mathematische System den folgenden Ausdruck annimmt:

wobei:

$C_{2m+1}$ die ungeraden Koeffizienten der Volterrareihe sind; $x_n$ ein Abtastwert des Eingangssignals ($a_n$) ist; $y_n$ der n-te Abtastwert am Ausgang des verzerrenden Leistungsverstärkers (6) ist; und die dreieckigen Klammern das Skalarprodukt der beiden durch Komma getrennten Argumente bedeutet.

10. Verfahren nach Anspruch 4, **dadurch gekennzeichnet, dass** die Rekursion im Schritt c) den folgenden Ausdruck annimmt:

$$c_{2i+1}(n+1) \quad \approx \quad c_{2i+1}(n) - \alpha\varepsilon_n \left|x_n\right|^{2i} x_n^* \quad \text{für } 0 \le i \le M \text{ und } c_{2i+1}(0)=0 \text{, wobei } c_{2m+1} \text{ die ungeraden Koef-}$$

fizienten der Volterrareihe sind; $x_n$ ein Abtastwert des Eingangssignals ($a_n$) ist; * komplexe Konjugation bedeutet;

und $\varepsilon_n \stackrel{\Delta}{=} c_1 x_n - z_n$ der Linearitätsfehler ist.

11. Linearisierer der Übertragungsfunktion eines verzerrenden Hochfrequenz-Leistungsverstärkers (6), **dadurch gekennzeichnet, dass** er Folgendes umfasst:

- erste digitale Signalverarbeitungsmittel (9), die dafür programmiert sind, eine gedächtnislose Volterrareihe ($u_n$) von Potenzen von Abtastwerten ($x_n$) eines Eingangssignals ($a_n$), die mit jeweiligen Koeffizienten ($\{c_{2l+1}\}_{i\neq0}$) der Potenzen multipliziert werden, beschränkt nur auf die nicht linearen Polynomterme ungerader Ordnung der Reihe, die die signifikantesten Intermodulationsprodukte, die durch den verzerrenden Verstärker (6) erzeugt werden, modellieren, zu berechnen;
- Hochfrequenzkoppelmittel (7), die dafür ausgelegt sind, den analogen Hochfrequenzwert der Reihe ($\widetilde{u}_n$) von dem verzerrten Signal ($\widetilde{y}_n$) am Ausgang des Hochleistungsverstärkers (6) zu subtrahieren, um so ein linearisiertes Übertragungssignal ($\widetilde{z}_n$) zu erhalten;
- zweiten digitale Signalverarbeitungsmittel (17, 23), die dafür programmiert sind, neue multiplikative Koeffizienten ($c_{2m+1}$) von Termen ungerader Ordnung der abgebrochenen Volterrareihe durch Auferlegen der Erzielung eines minimalen mittleren quadratischen Fehlers zwischen einer Basisband-Digitaldarstellung des linearisierten Übertragungssignals ($z_n$) und seinem digitalen linearen Gegenstück ($c_1 x_n$) zu berechnen.

12. Linearisierer nach Anspruch 11, **dadurch gekennzeichnet, dass** er Abtastmittel umfasst, die dafür gesteuert werden, das Eingangssignal ($a_n$) bis zu mindestens 2 $M$ mal die Symbolfrequenz überabzutasten, wobei 2 $M$ + 1 der Term höchster Ordnung abgebrochener Volterrareihen ist.

13. Linearisierer nach Anspruch 12, **dadurch gekennzeichnet, dass** die zweiten digitalen Signalverarbeitungsmittel (17) dafür programmiert sind, die Koeffizienten ($c_{2m+1}$) durch Lösen eines mathematischen Systems von linearen Gleichungen, das Abtastwerte ($x_n$) des Eingangssignals ($a_n$) und des Ausgangssignals ($y_n$) des verzerrenden Verstärkers (6) umfasst, in geschlossener Form zu berechnen.

14. Linearisierer nach Anspruch 12, **dadurch gekennzeichnet, dass** die zweiten digitalen Signalverarbeitungsmittel (23) dafür programmiert sind, die Koeffizienten ($c_{2m+1}$) rekursiv aus Abtastwerten ($x_n$) des Eingangssignals ($a_n$) und des linearisierten Übertragungssignals ($z_n$) zu berechnen.

15. Linearisierer nach Anspruch 12, **dadurch gekennzeichnet, dass** er erste digitale Verzögerungsmittel (8) der in die ersten digitalen Signalverarbeitungsmittel (9) eintretenden Abtastwerte ($x_n$) des Eingangssignals ($a_n$) zum zeitlichen Ausrichten der Terme der Volterrareihe auf die entsprechenden Intermodulationsprodukte umfasst.

16. Linearisierer nach Anspruch 12, **dadurch gekennzeichnet, dass** er zweite digitale Verzögerungsmittel (20, 25) der in die zweiten digitalen Signalverarbeitungsmittel (23) eintretenden Abtastwerte ($x_n$) zum zeitlichen Ausrichten dieser auf die Basisband-Digitaldarstellung des linearisierten Übertragungssignals ($y_n, z_n$) umfasst.

**17.** Linearisierer nach Anspruch 12, **dadurch gekennzeichnet, dass** signalabwärts der ersten digitalen Signalverarbeitungsmittel (9) eine Kaskade von Folgendem vorgesehen ist: Digital-Analog-Umsetzungsmittel (10), Mittel (11) zur Umsetzung in Hochfrequenz, Bandpassfilterungsmittel (12) mit einer Bandbreite von ungefähr viermal die Symbolfrequenz, lineare Leistungsverstärkungsmittel (12) zum Ausrichten des Leistungspegels des Verzerrungssignals ($\tilde{u}_n$) auf den Leistungspegel von zu löschenden Intermodulationsprodukten.

**18.** Linearisierer nach Anspruch 12, **dadurch gekennzeichnet, dass** er eine Kaskade von Folgendem umfasst:

- lineare Leistungsverstärkungsmittel (14) des Übertragungssignals ($y_n$, $z_n$) , das am Ausgang entweder des verzerrenden Hochleistungsverstärkers (6) oder der Hochfrequenzkoppelmittel (7) vorliegt;
- Bandpassfilterungsmittel (15) mit einer Bandbreite von ungefähr viermal die Symbolfrequenz;
- Hochfrequenz-Abwärtsumsetzungsmittel (16);
- signalaufwärts der zweiten digitalen Signalverarbeitungsmittel (17, 23) angeordnete Analog-Digital-Umsetzungsmittel (18).

## Revendications

**1.** Un procédé de linéarisation de la caractéristique de transfert d'un amplificateur de distorsion haute puissance à radiofréquence (6), **caractérisé en ce qu'**il comprend les opérations suivantes :

a) le calcul (9) d'une série de Volterra sans mémoire ($u_n$) de puissances d'échantillons ($x_n$) d'un signal d'entrée ($a_n$) multiplié par des coefficients respectifs ($\{c_{2i+1}\}_{i \neq 0}$) des puissances, de manière limitée aux seuls termes polynomiaux non linéaires d'ordre impair de la série modélisant les produits d'intermodulation les plus significatifs générés par l'amplificateur de distorsion,

b) la soustraction de la valeur de radiofréquence analogique de la série ($\tilde{u}_n$) du signal distordu ($\tilde{y}_n$) à la sortie de l'amplificateur haute puissance, pour obtenir ainsi un signal de transmission linéarisé ($\tilde{z}_n$),

c) le calcul de nouveaux coefficients multiplicatifs ($c_{2m+1}$) de termes d'ordre impair d'une série de Volterra tronquée en imposant l'atteinte d'une erreur quadratique moyenne minimale entre une représentation numérique de bande de base du signal de transmission linéarisé ($z_n$) et sa contrepartie linéaire numérique donnée par le terme de premier ordre ($c_1 x_n$) de la série de Volterra.

**2.** Le procédé selon la Revendication 1, **caractérisé en ce que** le signal d'entrée ($a_n$) est suréchantillonné jusqu'à au moins $2M$ fois la fréquence de symbole, où 2M + 1 est le terme d'ordre le plus élevé d'une série de Volterra tronquée.

**3.** Le procédé selon la Revendication 2, **caractérisé en ce que** l'opération de calcul de coefficient c) est effectuée par la résolution sous forme fermée d'un système mathématique d'équations linéaires comprenant des échantillons ($x_n$) du signal d'entrée ($a_n$) et du signal de sortie ($y_n$) de l'amplificateur de distorsion (6).

**4.** Le procédé selon la Revendication 2, **caractérisé en ce que** l'opération de calcul de coefficient c) est effectuée de manière récursive à partir d'échantillons ($x_n$) du signal d'entrée ($a_n$) et du signal de transmission linéarisé ($z_n$).

**5.** Le procédé selon la Revendication 2, **caractérisé en ce que** les échantillons ($x_n$) du signal d'entrée ($a_n$) sont opportunément retardés numériquement ($\tau_1$) avant d'être utilisés à l'opération a), alignant ainsi temporellement les termes de la série de Volterra sur les produits d'intermodulation correspondants présents dans le signal de sortie de l'amplificateur haute puissance (6).

**6.** Le procédé selon la Revendication 2, **caractérisé en ce que** les échantillons ($x_n$) du signal d'entrée ($a_n$) sont opportunément retardés numériquement ($\tau_2$) avant d'être utilisés à l'opération c), les alignant ainsi temporellement sur la représentation numérique de bande de base du signal de transmission linéarisé ($z_n$).

**7.** Le procédé selon la Revendication 2, **caractérisé en ce que**, à l'opération b), ladite valeur de radiofréquence analogique de la série de Volterra ($\tilde{u}_n$) fait l'objet de :

- un filtrage passe-bande avec une largeur de bande proche de $4F_S$, où $F_S$ est la fréquence de symbole,
- une amplification linéaire (12) destinée à aligner son niveau de puissance sur le niveau des produits d'intermodulation à annuler.

**8.** Le procédé selon la Revendication 1, **caractérisé en ce que** l'opération a) comprend :

- la prise du module de chaque échantillon ($x_n$),
- la multiplication de celui-ci par lui-même $2i$ fois pour chaque valeur de l'indice i incrémenté de manière unitaire pour admettre des valeurs de 1 à M,
- la multiplication de chaque puissance obtenue à l'opération précédente par l'échantillon effectif $(x_n)$ du signal d'entrée et par le coefficient respectif pour obtenir ainsi lesdits termes d'ordre impair d'une série de Volterra tronquée.

**9.** Le procédé selon la Revendication 3, **caractérisé en ce que** ledit système mathématique admet l'expression suivante :

$$\sum_{m=0}^{N} c_{2m+1}(|x_n|^{2m} x_n, |x_n|^{2i} x_n) = (y_n, |x_n|^{2i} x_n) \quad \text{pour} \quad 0 \leq i \leq M$$

où :

$c_{2m+1}$ sont les coefficients impairs de la série de Volterra, $x_n$ est un échantillon du signal d'entrée $(a_n)$ , $y_n$ est le n^ème échantillon à la sortie de l'amplificateur de puissance de distorsion (6), les parenthèses angulaires indiquent le produit scalaire des deux arguments séparés par une virgule.

**10.** Le procédé selon la Revendication 4, **caractérisé en ce que** la récursion à l'opération c) admet l'expression suivante :

$$c_{2i+1}(n+1) \approx c_{2i+1}(n) - \alpha \varepsilon_n |x_n|^{2i} x_n^* \quad \text{pour} \quad 0 \leq i \leq M \quad \text{et} \quad c_{2i+1}(0) = 0$$

pour $0 \leq i \leq M$ et $c_{2i+1}(0)=0$ où :

$c_{2m+1}$ sont les coefficients impairs de la série de Volterra, $x_n$ est un échantillon du signal d'entrée $(a_n)$, * indique

conjugué de manière complexe, $\varepsilon_n \stackrel{\hat{}}{=} c_1 x_n$ - $z_n$ est l'erreur de linéarité.

**11.** Un linéarisateur de la fonction de transfert d'un amplificateur de distorsion haute puissance à radiofréquence (6), **caractérisé en ce qu'**il comprend :

- un premier moyen de traitement du signal numérique (9) programmé de façon à calculer une série de Volterra sans mémoire ($u_n$) de puissances d'échantillons ($x_n$) d'un signal d'entrée ($a_n$) multipliée par des coefficients respectifs ($\{c_{2i+1}\}_{i \neq 0}$) des puissances, de manière limitée aux seuls termes polynomiaux non linéaires d'ordre impair de la série modélisant les produits d'intermodulation les plus significatifs générés par l'amplificateur de distorsion (6),
- un moyen de couplage à radiofréquence (7) configuré de façon à soustraire la valeur de radiofréquence analogique de la série ($\tilde{u}_n$) du signal distordu ($\tilde{y}_n$) à la sortie de l'amplificateur haute puissance (6), pour obtenir ainsi un signal de transmission linéarisé ($\tilde{z}_n$),
- un deuxième moyen de traitement du signal numérique (17, 23) programmé de façon à calculer de nouveaux coefficients multiplicatifs ($c_{2m+1}$) de termes d'ordre impair d'une série de Volterra tronquée en imposant l'atteinte d'une erreur quadratique moyenne minimale entre une représentation numérique de bande de base du signal de transmission linéarisé ($z_n$) et sa contrepartie linéaire numérique ($c_1 x_n$).

**12.** Le linéarisateur selon la Revendication 11, **caractérisé en ce qu'**il comprend un moyen d'échantillonnage commandé de façon à suréchantillonner le signal d'entrée ($a_n$) jusqu'à au moins 2M fois la fréquence de symbole, où 2M + 1 est le terme d'ordre le plus élevé d'une série de Volterra tronquée.

**13.** Le linéarisateur selon la Revendication 12, **caractérisé en ce que** le deuxième moyen de traitement du signal numérique (17) est programmé de façon à calculer lesdits coefficients ($c_{2m+1}$) par la résolution sous forme fermée d'un système mathématique d'équations linéaires comprenant des échantillons ($x_n$) du signal d'entrée ($a_n$) et du signal de sortie ($y_n$) de l'amplificateur de distorsion (6).

14. Le linéarisateur selon la Revendication 12, **caractérisé en ce que** le deuxième moyen de traitement du signal numérique (23) est programmé de façon à calculer lesdits coefficients ($c_{2m+1}$) de manière récursive à partir d'échantillons ($x_n$) du signal d'entrée ($a_n$) et du signal de transmission linéarisé ($z_n$).

15. Le linéarisateur selon la Revendication 12, **caractérisé en ce qu'**il comprend un premier moyen de retard numérique (8) des échantillons ($x_n$) du signal d'entrée ($a_n$) accédant à un premier moyen de traitement du signal numérique (9) de façon à aligner temporellement les termes de la série de Volterra sur les produits d'intermodulation correspondants.

16. Le linéarisateur selon la Revendication 12, **caractérisé en ce qu'**il comprend un deuxième moyen de retard numérique (20, 25) des échantillons ($x_n$) accédant au deuxième moyen de traitement du signal numérique (23) de façon à les aligner temporellement sur la représentation numérique de bande de base du signal de transmission linéarisé *($y_n$, $z_n$)*.

17. Le linéarisateur selon la Revendication 12, **caractérisé en ce qu'**en aval dudit premier moyen de traitement du signal numérique (9) est inclus une cascade composée de :

un moyen de conversion numérique à analogique (10), un moyen de conversion en radiofréquence (11), un moyen de filtrage passe-bande (12) avec une largeur de bande proche de quatre fois la fréquence de symbole, un moyen d'amplification de la puissance linéaire (12) destiné à aligner le niveau de puissance du signal de distorsion ($\tilde{u}_n$) sur le niveau de puissance des produits d'intermodulation à annuler.

18. Le linéarisateur selon la Revendication 12, **caractérisé en ce qu'**il comprend une cascade composée de :

- un moyen d'amplification de la puissance linéaire (14) du signal de transmission *($y_n$, $z_n$)* présent à la sortie soit de l'amplificateur de distorsion haute puissance (6) ou du moyen de couplage à radiofréquence (7),
- un moyen de filtrage passe-bande (15) avec une largeur de bande proche de quatre fois la fréquence de symbole,
- un moyen de conversion descendante en radiofréquence (16),
- un moyen de conversion analogique à numérique (18) placé en amont du deuxième moyen de traitement du signal numérique (17, 23).

# CONVENTIONAL BP NON LINEAR MODEL

**FIG.1**

# KNOWN SIGNAL REPRESENTATIONS

REAL BAND-PASS SIGNAL $\quad X(\omega)$

ANALYTIC BAND-PASS SIGNAL $\quad X^a(\omega)$

EQUIVALENT LOW-PASS SIGNAL $\quad \tilde{X}(\omega)$

**FIG.2**

EP 2 136 469 B1

KNOWN ART

TRANSMITTER

FIR TX $\rightarrow$ $\uparrow m$ $\xrightarrow{x_n}$ DPD $\xrightarrow{\tilde{x}_n}$ HPA

DPD: $x_n + \sum_{i=1}^{M} c_{2i+1} |x_n|^{2i} x_n$

$a_n$

RF CHANNEL $\tilde{y}_n$ $\oplus$ $\varsigma_n$ $\rightarrow$ RECEIVER

RETURN LINK $\{c_{2i+1}\}_{i \neq 0}$

**FIG.3**

KNOWN ART

$RF_{IN}$ $\xrightarrow{x_L}$ $\tau_1$ $\rightarrow$ HPA $\xrightarrow{y = y_L + y_D}$ AT $\rightarrow$ $\ominus$ $\xrightarrow{y_D}$ $\tau_2$ $\rightarrow$ $\ominus$ $\xrightarrow{y_L}$ $RF_{OUT}$

$A_1 ; \varphi_1$ $\rightarrow$ $LA_1$ $\xrightarrow{y_L}$

$A_2 ; \varphi_2$ $\rightarrow$ $LA_2$ $\xrightarrow{y_D}$

**FIG.4**

FIG.5

FIG.6

— · — · — · — 5B MASK    ————————— HPA OUTPUT WITHOUT LINEARIZATION

································ LINEAR

**128 QAM WITHOUT LINEARIZATION**
**ROLL-OFF = 0.2 - OBO = 12 dB**

FIG.7a

FIG.8a

FIG.8b

- - - - 5B MASK
........... LINEAR
──── HPA OUTPUT WITH PREDISTORTION

128 QAM WITH PREDISTORTION , M = 2
OBO = 6 dB  -  S/MSE = 50 dB

FIG.7b

- - - - HPA OUTPUT WITHOUT LINEARIZATION
──── HPA OUTPUT WITH HARMONIC CANCELLATION

128 QAM WITH HARMONIC CANCELLATION, M = 2
OBO = 3 dB  -  S/MSE = 48 dB

FIG.7c

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 03021767 A1
- US 20030234687 A1
- US 6683495 B
- WO 2005124995 A
- US 7333559 B
- US 20030227325 A1
- US 20030030487 A1
- GB 2380079 A
- EP 1280272 A1

**Non-patent literature cited in the description**

- **Yan Ye et al.** Generalized Hammerstein-Based Dynamic Nonlinear Behavior Models for Wideband RF Transmitters. *IEEE Wicom,* 2007
- **Zhu et al.** Pruning the Volterra Series for Behavioral Modeling of Power Amplfiers Using Physical Knowledge. *IEEE trans. on Microwave Theory and Techniques,* 2007
- **Ding et al.** Effects of Even-Order Nonlinear Terms on Power Amplifier Modeling and Predistortion Linearization. *IEEE trans. on Vehicular Technology,* 2004
- **E.G. Jeckeln ; F.M. Ghannouchi ; M. Sawan ; F. Bearegard.** Efficient baseband/RF feedforward linearizer through a mirror power amplifier using software-defined Radio and quadrature digital up-conversion. *IEEE MTT-S International Microwave Symposium Digest,* 2001, vol. 2
- **L. Erup ; M. Gardner ; R. A. Harris.** Interpolation in digital modems - Part II: Implementation and performance. *IEEE Transactions on Communications,* June 1993, vol. 41 (6), 997-1008
- **A.A.M. Saleh.** Frequency independent and frequency-dependent nonlinear model of TWT amplifier. *Transactions on Communications,* November 1981, vol. COM-29, 1715-1720
- **J.G. Proakis.** Digital Communications. McGraw-Hill, 2001